# DEMANDE DE BREVET EUROPEEN

(11) **EP 2 109 139 A2**
(43) Date de publication de la demande: **14.10.2009**
(21) Numéro de dépôt: 09157229.7
(22) Date de dépôt: 02.04.2009
(51) Int. Cl.: H01L 23/58

(54) **Dispositif de protection d'un circuit intégré contre une attaque par laser**

(30) Priorité: 03.04.2008 FR 0852215
(71) Demandeur: STMicroelectronics (Rousset) SAS, 13790 Rousset (FR)
(72) Inventeur: Lisart, Mathieu, 13100 Aix en Provence (FR); Pouget, Vincent, 33400 Talence (FR)
(74) Mandataire: de Beaumont, Michel

(57) **Abrégé**

L'invention concerne un circuit intégré (40) comprenant un substrat (12) d'un matériau semiconducteur ayant des première et seconde faces opposées (13) et incluant des zones actives (22, 24) affleurant la première face. Le circuit comprend un dispositif de protection (42) contre des attaques par laser, le dispositif de protection comprenant au moins une première région dopée (44) s'étendant entre au moins une partie des zones actives et la seconde face, un dispositif de polarisation de la première région et un dispositif de détection d'une augmentation du courant fourni par le dispositif de polarisation.

## Description

### Domaine de l'invention

La présente invention concerne les dispositifs de protection d'un circuit intégré contre des attaques extérieures.

### Exposé de l'art antérieur

Il peut être souhaitable de protéger un circuit intégré contre les attaques extérieures qui visent, par exemple, à perturber voire empêcher le fonctionnement normal du circuit intégré. Un exemple d'attaque consiste à balayer la face avant ou la face arrière du circuit intégré par un laser, notamment un laser pulsé. Un tel procédé peut permettre de modifier des données stockées dans des mémoires du circuit intégré ou de modifier les états logiques ou les durées de signaux transmis le long de pistes conductrices du circuit intégré.

Le circuit intégré peut comprendre un dispositif de protection qui permet de détecter qu'une attaque par laser est réalisée. Le dispositif de protection peut alors commander l'arrêt du circuit intégré, l'effacement de données confidentielles, etc.

A titre d'exemple, le dispositif de protection contre les attaques par laser peut comprendre plusieurs composants électroniques, par exemple des photodiodes, des éléments mémoires de type bascule (flip flop), formés dans le circuit intégré. Ces composants électroniques sont sensibles au faisceau lumineux du laser et jouent le rôle de capteurs permettant de détecter la présence du faisceau laser.

Toutefois, un tel dispositif de protection ne permet de détecter une attaque par laser que si le faisceau laser atteint directement l'un des capteurs du dispositif de protection. Pour assurer une forte probabilité de détection d'une attaque lors d'un balayage laser sur toute une région d'un circuit intégré, il est nécessaire de prévoir un nombre élevé de capteurs. Ceci se traduit par une augmentation de la surface du circuit intégré dédiée au dispositif de protection et donc du coût de fabrication du circuit intégré.

### Résumé

La présente invention vise un dispositif de protection d'un circuit intégré contre les attaques laser permettant de protéger une portion importante du circuit intégré sans nécessiter une augmentation importante de la surface du circuit intégré.

Selon un autre objet, le dispositif de protection permet à la fois la détection d'attaques par laser continu et par laser pulsé.

Ainsi, un exemple de réalisation de la présente invention prévoit un circuit intégré comprenant un substrat d'un matériau semiconducteur ayant des première et seconde faces opposées et incluant des zones actives affleurant la première face. Le circuit intégré comprend un dispositif de protection contre des attaques par laser. Le dispositif de protection comprend au moins une première région dopée s'étendant entre au moins une partie des zones actives et la seconde face, un dispositif de polarisation de la première région et un dispositif de détection d'une augmentation du courant fourni par le dispositif de polarisation.

Selon un exemple de réalisation de la présente invention, la première région dopée est d'un premier type de conductivité et les zones actives comprennent un réseau de deuxièmes régions dopées du premier type de conductivité et de troisièmes régions dopées d'un second type de conductivité, chaque deuxième et troisième régions s'étendant dans le substrat depuis la première face, la première région s'étendant au moins au niveau de certaines des deuxième et troisième régions.

Selon un exemple de réalisation de la présente invention, le circuit intégré comprend une quatrième région du second type de conductivité s'étendant dans le substrat depuis la première face, entourant au moins partiellement les zones actives, au niveau desquelles s'étend la première région, et destinée à être reliée à un dispositif de polarisation supplémentaire du substrat.

Selon un exemple de réalisation de la présente invention, le circuit intégré comprend des composants électroniques au moins en partie dans les zones actives, les composants étant cadencés par un signal d'horloge et le dispositif de détection comprend un premier module de fourniture d'un premier signal représentatif dudit courant, un second module de fourniture d'un second signal qui dépend de la comparaison du premier signal et d'un troisième signal de référence et un module d'échantillonnage du troisième signal à des instants en dehors d'une durée non nulle suivant chaque front montant du signal d'horloge.

Selon un exemple de réalisation de la présente invention, le dispositif de polarisation comprend un transistor MOS et le premier module comprend une résistance en série avec le transistor.

Selon un exemple de réalisation de la présente invention, le dispositif d'échantillonnage est adapté à échantillonner le troisième signal à chaque front descendant du signal d'horloge.

Un autre exemple de réalisation de la présente invention prévoit un système électronique comprenant un premier circuit intégré tel qu'on l'a décrit ci-dessus, un second circuit intégré distinct du premier circuit intégré et au moins une liaison reliant le premier circuit intégré au second circuit intégré.

Un autre exemple de réalisation de la présente invention prévoit un procédé de fabrication d'un circuit intégré comprenant un substrat d'un matériau semiconducteur, ayant des première et seconde faces opposées et comportant un dispositif de protection contre des attaques par laser. Le procédé comprend les étapes consistant à former au moins une première région dopée en profondeur dans le substrat, à former des zones actives s'étendant dans le substrat depuis la première face, la première région s'étendant entre au moins une partie des zones actives et la seconde face, à former un dispositif de polarisation de la première région et à former un dispositif de détection d'une augmentation du courant fourni par le dispositif de polarisation.

Selon un exemple de réalisation de la présente invention, le procédé comprend les étapes consistant à former la première région par une première implantation de dopants d'un premier type de conductivité à une première énergie et à former les zones actives par un réseau de deuxièmes régions dopées du premier type de conductivité et de troisièmes régions dopées d'un second type de conductivité, la première région s'étendant au moins au niveau de certaines des deuxièmes et troisièmes régions, les deuxièmes régions étant formées par une seconde implantation de dopants du premier type de conductivité à une seconde énergie inférieure à la première énergie.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est une coupe schématique d'un exemple de circuit intégré classique ;
la figure 2 est une coupe schématique d'un exemple de réalisation d'un circuit intégré muni d'un dispositif de protection selon l'invention ;
la figure 3 est une vue de dessous schématique d'une variante du circuit intégré de la figure 2 ;
la figure 4 représente un exemple de réalisation d'un circuit de détection du dispositif de protection selon l'invention ;
la figure 5 est un chronogramme de signaux caractéristiques du fonctionnement du circuit de détection de la figure 4 ;
la figure 6 est un schéma par blocs illustrant un exemple de procédé de fabrication du dispositif de protection selon l'invention ; et
la figure 7 représente, de façon schématique, un exemple de système électronique comprenant un circuit intégré muni du dispositif de protection selon l'invention.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle. Dans la suite de la description, on appelle zones actives d'un circuit intégré, les parties du substrat du circuit intégré au niveau desquelles sont formés des composants électroniques tels que des transistors, des diodes, etc. Plus précisément, dans le cadre de l'invention, on considère des circuits intégrés pour lesquels les zones actives s'étendent dans le substrat, depuis une face du substrat, seulement sur une partie de la profondeur du substrat.

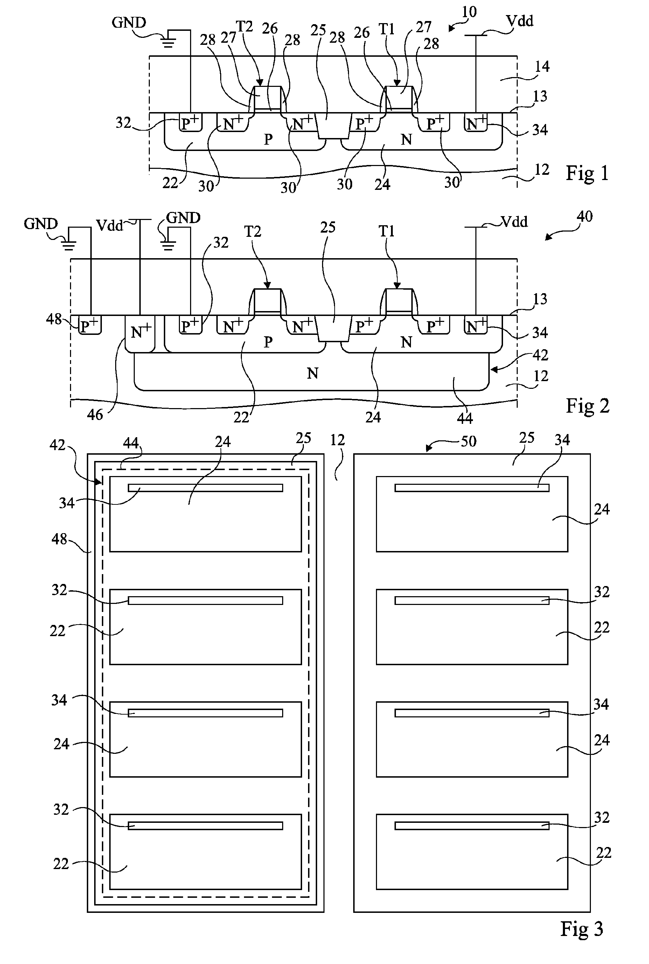

La figure 1 est une coupe schématique d'un exemple de circuit intégré classique. Le circuit intégré 10 comprend un substrat 12 d'un matériau semiconducteur. Il s'agit, par exemple, d'un substrat 12 de silicium monocristallin non dopé ou dopé de type P. Le substrat 12 comprend une face 13 recouverte d'un empilement de couches isolantes (seule une couche isolante 14 étant représentée en figure 1). Le circuit 10 comprend une région 22 dopée de type P et une région 24 dopée de type N s'étendant dans le substrat 12 depuis la face 13. Les régions 22 et 24 forment des caissons et sont séparées latéralement l'une de l'autre par une région isolante 25 formée dans le substrat 12, par exemple selon un procédé d'isolation par tranchée profonde ou STI (Shallow Trench Isolation). Le circuit 10 peut comprendre plusieurs caissons 22 et 24, par exemple disposés en rangées et en colonnes. Des composants électriques sont prévus au niveau des caissons 22, 24. A titre d'exemple, on a représenté un transistor T1 à canal P au niveau du caisson 24 et un transistor T2 à canal N au niveau du caisson 22. De façon classique, chaque transistor T1, T2 comprend une portion isolante 26 recouvrant le substrat 12 et formant l'isolant de grille du transistor T1, T2, une portion 27 d'un matériau semiconducteur recouvrant la portion isolante 26 et formant la grille du transistor T1, T2, des espaceurs 28 entourant la grille 27 et des régions dopées 30 s'étendant dans le substrat 12, disposées de part et d'autre de la grille 27 et formant les régions de source et de drain du transistor T1, T2.

Une région 32 de type P, plus fortement dopée que la région 22, s'étend dans la région 22 depuis la face 13. La région 32 est connectée à une source d'un premier potentiel de référence, par exemple la masse GND, assurant la polarisation du caisson 22 et du substrat 12. Une région 34 de type N, plus fortement dopée que la région 24, s'étend dans la région 24 depuis la face 13. La région 34 est connectée à une source d'un second potentiel de référence, par exemple Vdd, supérieur au premier potentiel de référence GND et assurant la polarisation du caisson 24.

Un exemple de réalisation de la présente invention consiste à prévoir dans le substrat du circuit intégré, entre la face arrière du circuit intégré et les zones actives, au moins un écran de protection constitué d'une région dopée formée en profondeur dans le substrat. L'écran de protection est adapté à capturer des électrons photogénérés principalement au niveau de la jonction entre la région dopée formant l'écran de protection et le substrat adjacent lors du passage d'un faisceau laser. Un circuit de détection, relié à l'écran de protection, est adapté à détecter une variation d'une grandeur électrique due au passage d'un faisceau laser. En particulier, la variation de la grandeur électrique peut correspondre à une variation de courant. La détection d'une attaque peut entraîner l'émission d'un signal d'alerte qui peut commander l'arrêt du circuit intégré, l'effacement de données confidentielles, etc. Le présent exemple de réalisation est avantageusement adapté à la fois à la détection d'une attaque par un laser continu ou par un laser pulsé.

La figure 2 est une coupe schématique d'un exemple de réalisation d'un circuit intégré 40 comprenant un dispositif de protection 42 selon l'invention. Le circuit intégré 40 reprend les éléments du circuit 10 de la figure 1. Le dispositif de protection 42 comprend une région 44 dopée de type N formée dans le substrat 12 en dessous des caissons 22, 24. De façon générale, la région 44 peut avoir la forme d'un écran qui s'étend sous certains caissons 22, 24 du circuit intégré. Comme cela sera décrit plus en détail par la suite, le dispositif de protection 42 comprend également un circuit de détection, non représenté en figure 2, et relié à l'écran de protection 44.

L'écran de protection 44 peut être en contact avec le caisson 24. La polarisation de l'écran de protection 44 peut alors être réalisée par l'intermédiaire du caisson 24 relié à la source du potentiel Vdd. Une région 46 de type N peut s'étendre dans le substrat 12 depuis la face 13 jusqu'à la région 44. La région 46 peut alors être connectée à la source du potentiel Vdd pour polariser l'écran de protection 44.

La polarisation du caisson 22 est réalisée par la région 32 reliée à la masse GND. Le caisson 22 pouvant être électriquement isolé du reste du substrat 12, la polarisation du substrat 12 peut devoir être réalisée séparément de la polarisation du caisson 22. Pour ce faire, on peut prévoir une région dopée de type P 48, plus fortement dopée que le substrat 12 et qui s'étend dans le substrat 12 depuis la face 13. La région 48 est connectée à la masse GND afin de polariser le substrat 12.

La figure 3 représente une vue de dessous schématique d'un circuit intégré 50 correspondant à une variante du circuit intégré 40 de la figure 2. En figure 3, on a représenté schématiquement en traits pleins le contour des caissons 22, 24 et des régions isolantes 25. Les caissons 22, 24 sont répartis en figure 3 selon deux colonnes. Le contour de l'écran de protection 44 est représenté en traits pointillés. L'écran de protection 44 s'étend seulement sous les caissons 22, 24 de la colonne représentée à gauche en figure 3. Le contour de la région 48 est représenté en traits pleins. La région 48 a, par exemple, la forme d'un anneau entourant les caissons 22, 24 protégés par l'écran de protection 44. Le contour des régions 32 et 34 est représenté en traits pleins. Les régions 32 associées aux caissons 22 protégés par l'écran 44 assurent essentiellement la polarisation de ces caissons 22. Les régions 32 associées aux caissons 22 non protégés par l'écran 44 assurent la polarisation de ces caissons 22 et du substrat 12. Par rapport au circuit 40, le circuit 50 ne comprend pas la région 46. Toutefois, à titre de variante, la polarisation de l'écran 44 peut également être réalisée par une ou plusieurs régions 46 en plus des caissons 22. Selon une autre variante, la polarisation de l'écran 44 peut être seulement réalisée par une ou plusieurs régions 46.

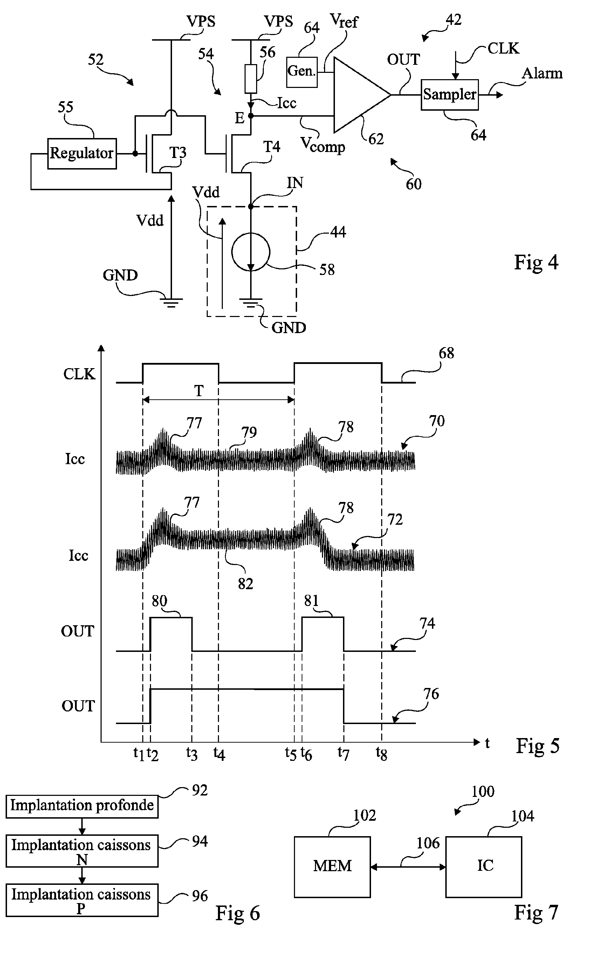

La figure 4 est un schéma électrique d'un exemple de réalisation du dispositif de protection 42 dans le cas où le circuit intégré 40 est un circuit synchrone. De façon classique, le circuit intégré 40 comprend un module principal de fourniture du potentiel de référence Vdd et des modules secondaires de fourniture du potentiel de référence. Chaque module d'alimentation secondaire est associé à une portion du circuit intégré, par exemple un ensemble de caissons. A titre d'exemple, chaque module d'alimentation secondaire assure la polarisation des caissons dopés de type N auxquels il est associé. Selon un exemple de réalisation de la présente invention, la structure du module d'alimentation secondaire associé à un ensemble de caissons protégés par un écran de protection est modifiée et un circuit de détection d'une attaque par laser est associé au module d'alimentation secondaire modifié.

Dans le présent exemple de réalisation, le circuit d'alimentation principal 52 comprend un transistor MOS T3 à canal N dont le drain est relié à une source d'un potentiel VPS, supérieur ou égal au potentiel de référence Vdd, et dont la source est reliée à une entrée d'un module de régulation 55 (Regulator). La sortie du module 55 polarise la grille du transistor T3. Le module 55 est adapté à faire varier la tension de grille du transistor T3 de façon que la tension à la source du transistor T3 reste sensiblement constante et égale à Vdd. A titre d'exemple, le potentiel Vdd est de 1,3 volt et le potentiel VPS est compris entre 2 et 5 volts. Chaque module d'alimentation secondaire, un seul module d'alimentation secondaire 54 étant représenté en figure 4, comprend un transistor MOS T4 à canal N dont la grille est reliée à la grille du transistor T3. La source du transistor T4 est reliée à une borne IN destinée à être reliée, entre autres, aux caissons de type N de la portion du circuit intégré 40 associée au module d'alimentation secondaire 54. Pour un module d'alimentation secondaire relié à une portion du circuit intégré 40 non protégée par un écran de protection 44, le drain du transistor T4 est relié directement à la source du potentiel VPS.

Selon le présent exemple de réalisation, le module secondaire 54 associé à une portion du circuit intégré 40 dont les caissons 22, 24 sont protégés par un écran de protection 44 comprend, en outre, une résistance 56 dont une borne est reliée à la source du potentiel VPS et dont l'autre borne est reliée au drain du transistor T4. On désigne par la référence E un noeud situé entre la résistance 56 et le drain du transistor T4. On appelle Icc le courant au noeud E.

Le bloc en traits pointillés correspond à l'écran de protection 44. En l'absence d'attaque par laser ou entre deux impulsions lors d'une attaque par un laser pulsé, l'écran 44 est équivalent à une source d'un courant nul. Lorsqu'un faisceau laser atteint le circuit intégré 40, l'écran de protection 44 tend à capturer des électrons photogénérés principalement au niveau de la jonction entre la région 44 et le substrat 12 adjacent. Il est alors équivalent à une source de courant 58 dont une borne est reliée à la borne IN et dont l'autre borne est reliée à la masse GND. La source de courant 58 tire un courant Iₚᵤₗₛₑ non nul approximativement constant pendant toute la durée pendant laquelle la région 44 est exposée au faisceau laser.

Le circuit de détection 60 comprend un comparateur 62 ayant une première entrée reliée au noeud E et recevant un signal V_{comp}, par exemple, la tension au noeud E. Une seconde entrée du comparateur 62 reçoit un signal de référence V_{ref} fourni par un module 64. Le signal de référence V_{ref} correspond, par exemple, au potentiel VPS. Le comparateur 62 fournit un signal OUT qui peut correspondre à un signal à deux états. A titre d'exemple, le signal OUT est à un état haut lorsque la tension V_{comp} est inférieure à V_{ref} et est à un état bas lorsque la tension V_{comp} est supérieure ou égale à V_{ref}. Le signal OUT est échantillonné par un échantillonneur 64 (Sampler) cadencé par un signal d'horloge CLK associé à la portion de circuit alimentée par le module d'alimentation secondaire 54. L'échantillonneur 64 fournit un signal d'alarme Alarm correspondant à une succession de valeurs échantillonnées du signal OUT.

La figure 5 est un chronogramme de signaux caractéristiques du dispositif de protection 42 de la figure 4. On appelle t₁ à t₈ des instants successifs. La courbe 68 représente le signal d'horloge CLK. Les courbes 70 et 72 représentent l'évolution du courant Icc respectivement en l'absence et en présence d'une attaque par laser. Les courbes 74 et 76 représentent l'évolution du signal OUT respectivement en l'absence et en présence d'une attaque par laser. Le signal d'horloge CLK est un signal périodique de période T, et correspond, par exemple, à un signal en créneaux de rapport cyclique 1/2. A titre d'exemple, la période T du signal CLK est de l'ordre de quelques nanosecondes à quelques dizaines de nanosecondes. Dans le présent exemple de réalisation, le signal CLK comporte un front montant aux instants t₁ et t₅ et un front descendant aux instants t₄ et t₈. Le signal d'horloge CLK peut cadencer tous ou certains des composants électroniques protégés par l'écran 44.

De façon classique, pour un circuit intégré synchrone, on constate des appels de courant peu après chaque front montant du signal d'horloge CLK. Ceci se traduit par des pics 77, 78 sur les courbes 70, 72 peu après les instants t₁ et t₅. La durée d'un pic est, par exemple, de l'ordre de 1 à quelques nanosecondes.

En fonctionnement normal, l'écran de protection 44 est électriquement équivalent à une source de courant nul. De ce fait, entre deux appels de courant 77, 78, le courant Icc fluctue autour de la valeur nulle (palier 79). Lorsque le courant Icc est sensiblement nul, le potentiel au noeud E est sensiblement égal à VPS. Le signal OUT est alors à l'état bas. A chaque pic d'appel de courant 77, 78, l'élévation du courant Icc entraîne une diminution du potentiel au noeud E en raison de l'augmentation du courant traversant la résistance 56. Le signal OUT bascule alors du niveau bas au niveau haut à l'instant t₂ (et à l'instant t₆). A la fin de chaque pic d'appel de courant 77, 78, lorsque le courant Icc redevient sensiblement nul, le potentiel au noeud E s'élève sensiblement à la valeur VPS de sorte que le signal OUT bascule au niveau bas à l'instant t₃ (et à l'instant t₇). En l'absence d'attaque par laser, le signal OUT correspond à une succession sensiblement périodique d'impulsions 80, 81 de même période que le signal CLK.

Lorsque la portion du circuit intégré 40 protégée par l'écran de protection 44 est soumise à une attaque par laser, l'écran de protection 44 est électriquement équivalent à la source 58 du courant Iₚᵤₗₛₑ. En outre, dans le cas d'un laser pulsé, l'écran de protection 44 est équivalent à une source de courant nul entre deux impulsions du laser. Dans le présent exemple, on considère qu'une impulsion d'un laser est appliquée sensiblement entre les instants t₁ et t₅. On constate alors, qu'après le pic 77 d'appel de courant, le courant Icc se stabilise à un palier 82 non nul, sensiblement égal au courant Iₚᵤₗₛₑ, jusqu'au pic d'appel de courant 78 suivant. Le signal OUT qui est passé de l'état bas à l'état haut à l'instant t₂ au début du pic 77 d'appel de courant, reste à l'état haut jusqu'à l'instant t₇, c'est-à-dire à la fin du pic 78 d'appel de courant suivant, auquel il repasse à l'état bas.

L'échantillonneur 64 est commandé pour réaliser un échantillonnage du signal OUT entre les instants t₃ et t₆. En fonctionnement normal, le signal OUT est à l'état bas entre les instants t₃ et t₆. De ce fait, si la valeur échantillonnée Alarm du signal OUT est à l'état haut, cela signifie qu'une attaque par laser est en cours. L'instant d'échantillonnage peut être fixe d'un cycle d'horloge à l'autre ou peut varier d'un cycle d'horloge à l'autre. A titre d'exemple, l'échantillonnage peut être réalisé à chaque front descendant du signal d'horloge CLK (instants t₄ et t₈).

Dans le cas où l'instant d'échantillonnage est fixe d'un cycle d'horloge à l'autre, on pourrait imaginer une attaque par un laser pulsé dans laquelle les impulsions laser seraient synchronisées avec le signal d'horloge CLK de façon que l'instant d'échantillonnage ait toujours lieu entre deux impulsions, l'attaque n'étant alors pas détectée. Une telle attaque n'est en fait pas réalisable en raison des fluctuations naturelles de la période du signal d'horloge CLK ou gigue (en anglais jitter) qui se traduisent par une variation de la période des instants d'échantillonnage.

Pour un circuit intégré asynchrone, en l'absence d'une attaque laser, le courant Icc ne comprend généralement pas de pics 77, 78 mais présente un niveau pouvant être sensiblement constant et non nul. Dans ce cas, le circuit de détection 42 peut ne pas comprendre l'échantillonneur 64. La tension de référence V_{ref} est déterminée de façon que, en l'absence d'une attaque laser, la tension V_{comp} soit supérieure à la tension V_{ref}. Le signal OUT est alors, par exemple, au niveau bas. Lors d'une attaque par un laser continu ou pulsé, le niveau de courant Icc s'élève. La tension de référence V_{ref} est déterminée de façon que, lors d'une attaque laser, la tension V_{comp} devienne inférieure à la tension V_{ref}. Le signal OUT passe alors à l'état haut. De ce fait, le passage du signal OUT de l'état bas à l'état haut correspond directement à la détection d'une attaque laser.

Ainsi, de façon générale la présente invention prévoit la détection d'une augmentation durable du courant Icc fourni par le dispositif de polarisation. On entend par augmentation durable une augmentation s'étendant pendant plus que la durée d'une impulsion de synchronisation, comme l'illustrent les signaux 70 et 72.

La figure 6 représente un schéma par blocs illustrant un exemple de procédé de fabrication de l'écran de protection 44 du dispositif de protection 42.

A une première étape 92, on prévoit le substrat 12 de silicium monocristallin qui est, par exemple, dopé de type P. Une implantation profonde est alors réalisée dans le substrat 12. A titre d'exemple, l'implantation est réalisée avec du phosphore, avec une dose de l'ordre de 1.10¹³ atomes/cm² et avec une énergie de l'ordre de 1,5 MeV. On forme ainsi la région 44 qui s'étend dans le substrat 12 à partir d'une profondeur de 1 à quelques micromètres, par exemple 1,7 µm, depuis la face supérieure 13 du substrat 12.

A l'étape 94, on réalise une implantation moins profonde pour former les caissons 24 de type N et les régions 46. A titre d'exemple, l'implantation est réalisée avec du phosphore, avec une dose de l'ordre de 7.10¹² atomes/cm² et avec une énergie de l'ordre de 440 keV. Ceci permet d'obtenir des régions de type N 24, 46 qui s'étendent dans le substrat 12 depuis la face supérieure 13 jusqu'à des profondeurs de 1 à quelques micromètres, par exemple 1,7 micromètres. Les régions 24, 46 s'étendent suffisamment profondément dans le substrat 12 pour assurer une continuité électrique avec l'écran 44.

A l'étape 96, on réalise une implantation pour former les caissons 22 de type P. A titre d'exemple, l'implantation est réalisée avec du bore, avec une dose de l'ordre de 5.10¹² atomes/cm² et avec une énergie de l'ordre de 200 keV.

Certains circuits intégrés peuvent comprendre un écran d'isolation constitué d'une région dopée formée en profondeur dans le substrat et s'étendant sous des zones actives du substrat pour les isoler électriquement de perturbations électriques provenant du substrat. Il s'agit par exemple de circuits intégrés comprenant des mémoires volatiles, l'écran d'isolation étant, par exemple, prévu au niveau des cellules mémoire. Les procédés de fabrication de tels circuits intégrés comprennent dans ce cas une étape d'implantation profonde. Le présent exemple de réalisation selon l'invention peut alors être mis en oeuvre pour de tels circuits intégrés sans en modifier le procédé de fabrication, la formation de l'écran de protection 44 étant réalisée simultanément à la formation de l'écran d'isolation, l'écran de protection 44 étant formé au niveau des zones actives du circuit intégré à protéger contre les attaques par laser et l'écran d'isolation étant formé au niveau des zones actives du circuit intégré à isoler du substrat.

La figure 7 représente, de façon schématique, un circuit électronique 100 comprenant une mémoire 102 (MEM), par exemple une mémoire volatile, comprenant un dispositif de protection tel que décrit précédemment. Le circuit électronique 100 comprend, en outre, un autre circuit intégré 104 (IC), par exemple un circuit d'interface, relié à la mémoire 102 par une liaison 106, par exemple pour l'écriture de données dans la mémoire 102 ou la lecture de données stockées dans la mémoire 102.

Des modes de réalisation particuliers de la présente invention ont été décrits. Diverses variantes et modifications apparaîtront à l'homme de l'art. En particulier, bien que la présente invention ait été décrite pour un circuit intégré dont le substrat est neutre ou dopé de type P et dans lequel l'écran de protection 44 du dispositif de protection 42 correspond à une région dopée de type N, il est clair que la présente invention peut s'appliquer à un substrat dopé de type N ou comprenant, en surface, une couche dopée de type N. Dans ce cas, le cordon correspond à une région dopée de type P formée en profondeur dans le substrat.

## Revendications

1. Circuit intégré (40) comprenant un substrat (12) d'un matériau semiconducteur ayant des première et seconde faces opposées (13) et incluant des zones actives (22, 24) affleurant la première face, **caractérisé en ce qu'**il comprend un dispositif de protection (42) contre des attaques par laser, le dispositif de protection comprenant :
au moins une première région dopée (44) s'étendant entre au moins une partie des zones actives et la seconde face ;
un dispositif de polarisation (54) de la première région ; et
un dispositif de détection (60) d'une augmentation durable du courant (Icc) fourni par le dispositif de polarisation.

2. Circuit selon la revendication 1, dans lequel la première région dopée (44) est d'un premier type de conductivité et dans lequel les zones actives comprennent un réseau de deuxièmes régions dopées (24) du premier type de conductivité et de troisièmes régions dopées (22) d'un second type de conductivité, chaque deuxième et troisième régions s'étendant dans le substrat (12) depuis la première face (13), la première région s'étendant au moins au niveau de certaines des deuxième et troisième régions.

3. Circuit selon la revendication 1 ou 2, comprenant une quatrième région (48) du second type de conductivité s'étendant dans le substrat (12) depuis la première face (13), entourant au moins partiellement les zones actives (22, 24), au niveau desquelles s'étend la première région (44), et destinée à être reliée à un dispositif de polarisation (GND) supplémentaire du substrat (12).

4. Circuit selon l'une quelconque des revendications précédentes, comprenant des composants électroniques (T1, T2) au moins en partie dans les zones actives (22, 24), les composants étant cadencés par un signal d'horloge (CLK), et dans lequel le dispositif de détection (60) comprend :
un premier module (54) de fourniture d'un premier signal (V_{comp}) représentatif dudit courant (Icc) ;
un second module (62) de fourniture d'un second signal (OUT) qui dépend de la comparaison du premier signal et d'un troisième signal de référence (VPS) ; et
un module d'échantillonnage (64) du second signal à des instants en dehors d'une durée non nulle suivant chaque front montant du signal d'horloge.

5. Circuit selon la revendication 4, dans lequel le dispositif de polarisation comprend un transistor MOS (T4) et dans lequel le premier module comprend une résistance (56) en série avec le transistor MOS.

6. Circuit selon la revendication 4, dans lequel le dispositif d'échantillonnage (64) est adapté à échantillonner le second signal (OUT) à chaque front descendant du signal d'horloge (CLK).

7. Système électronique (100) comprenant un premier circuit intégré (102) selon l'une quelconque des revendications précédentes, un second circuit intégré (104) distinct du premier circuit intégré et au moins une liaison (106) reliant le premier circuit intégré au second circuit intégré.

8. Procédé de fabrication d'un circuit intégré (40) comprenant un substrat (12) d'un matériau semiconducteur, ayant des première et seconde faces opposées (13) et comportant un dispositif de protection contre des attaques par laser, le procédé comprenant les étapes suivante :
former au moins une première région dopée (44) en profondeur dans le substrat ;
former des zones actives (22, 24) s'étendant dans le substrat depuis la première face, la première région s'étendant entre au moins une partie des zones actives et la seconde face ;
former un dispositif de polarisation (54) de la première région ; et
former un dispositif de détection (60) d'une augmentation du courant (Icc) fourni par le dispositif de polarisation.

9. Procédé selon la revendication 8, comprenant les étapes suivante :
former la première région (82) par une première implantation de dopants d'un premier type de conductivité à une première énergie ; et
former les zones actives par un réseau de deuxièmes régions dopées (24) du premier type de conductivité et de troisièmes régions dopées (22) d'un second type de conductivité, la première région (44) s'étendant au moins au niveau de certaines des deuxièmes et troisièmes régions, les deuxièmes régions étant formées par une seconde implantation de dopants du premier type de conductivité à une seconde énergie inférieure à la première énergie.
